Europäisches Patentamt

**European Patent Office**

**Office européen des brevets**

(19)

(11) Publication number: **0 148 765**
**A2**

(12) # EUROPEAN PATENT APPLICATION

(21) Application number: **85300051.1**

(22) Date of filing: **04.01.85**

(51) Int. Cl.⁴: **H 05 K 5/02**

(30) Priority: **10.01.84 GB 8400493**

(43) Date of publication of application: **17.07.85 Bulletin 85/29**

(84) Designated Contracting States: **BE DE FR GB IT NL SE**

(71) Applicant: **Lucas Electrical Electronics & Systems Limited, Well Street, Birmingham B19 2XF (GB)**

(72) Inventor: **Barratt, Derek Austin, 29 New Way Road, Colindale London NW9 6PL (GB)**

(74) Representative: **Carpenter, David et al, Marks & Clerk Alpha Tower Suffolk Street Queensway, Birmingham B1 1TT (GB)**

(54) **Instrument housing.**

(57) A housing for vehicle instruments includes first and second housing units (10a, 10b; 11a, 11b) to be positioned side-by-side, and a connecting piece (13) which, when the two units are positioned side-by-side, is engageable simultaneously with both units, the connecting piece (13) and the units being such that during engagement of the connecting piece (13) with the units a wedging action is achieved pressing the two units together.

"INSTRUMENT HOUSING"

This invention relates to a housing, assembled in modular form, for instruments primarily, but not exclusively, in a road vehicle.

It is known from German Specification 29 46 998 to construct an instrument housing from a plurality of individual units or modules which are positioned side-by-side. This specification also discloses the use of H-section connecting pieces which locate in apertures in the walls of adjacent units to locate the units in position relative to one another. The arrangement disclosed in German Specification 29 46 998 is disadvantageous in that in order to ensure correct fitting of the connecting pieces extreme accuracy in the manufacture of the individual units and connecting pieces is necessary, and even given a high degree of manufacturing accuracy, the connecting pieces themselves do not provide a secure fixing of the units one to another, but instead permit undesirable flexing of the assembled housing. It is an object of the present invention to produce an instrument housing construction wherein the disadvantages of the known arrangement are minimised.

A housing in accordance with the present invention includes first and second housing units to be positioned side-by-side, and a connecting piece which, when the two units are positioned side-by-side, is engageable simultaneously with both units, the connecting piece and the units being such that during engagement of the connecting piece with the units a wedging action is achieved pressing the two units together.

Preferably the units are moulded in a synthetic resin material, and are provided on their mutually presented faces with contact pads, the surfaces of which are parallel to the axis of their respective unit, the contact pads of one unit engaging the contact pads of the other unit when the two units are secured together so that the units are clamped together by the connecting piece with their axes in parallel planes.

Preferably in addition to the connecting piece there is provided a bridging member which engages the first and second units in a manner to resist twisting of the units, and thus to position the units relative to one another so that their axes are parallel.

Conveniently said connecting piece comprises a pair of wedge members interconnected in spaced relationship by an integral limb extending transverse to the length of the wedge members.

Desirably each unit is formed with a T-section slot for receiving the respective wedge member of a connecting piece.

One example of the present invention is illustrated in the accompanying drawings wherein:-
Figure 1 is an exploded perspective view of a pair of housing units positioned side by side;
Figure 2 is an inverted plan view of a pair of similar housing units assembled but with parts omitted for clarity;
Figure 3 is a view in the direction of arrow X in Figure 2;
Figure 4 is a sectional view on the line 4-4 in Figure 2;
Figure 5 is a side elevational view of a connecting piece;

Figure 6 is a top plan view of the connecting piece of Figure 5;

Figure 7 is an underneath plan view of the connecting piece of Figure 5;

Figure 8 is a sectional view on the line 8-8 in Figure 5;

Figure 9 is an underneath plan view of a bridging member; and

Figure 10 is a sectional view on the line 10-10 of Figure 9.

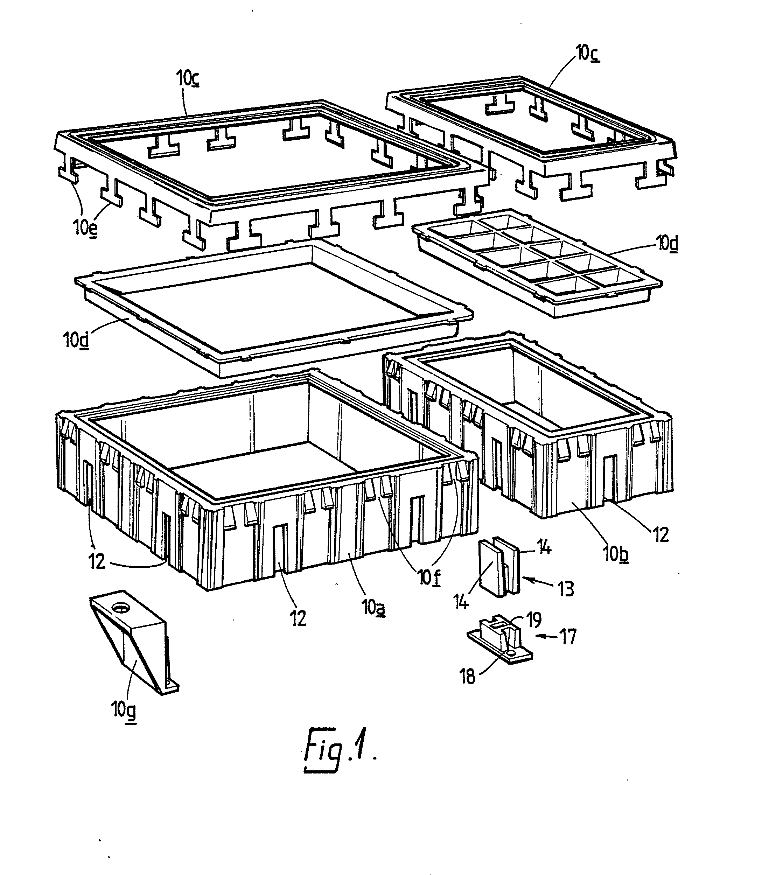

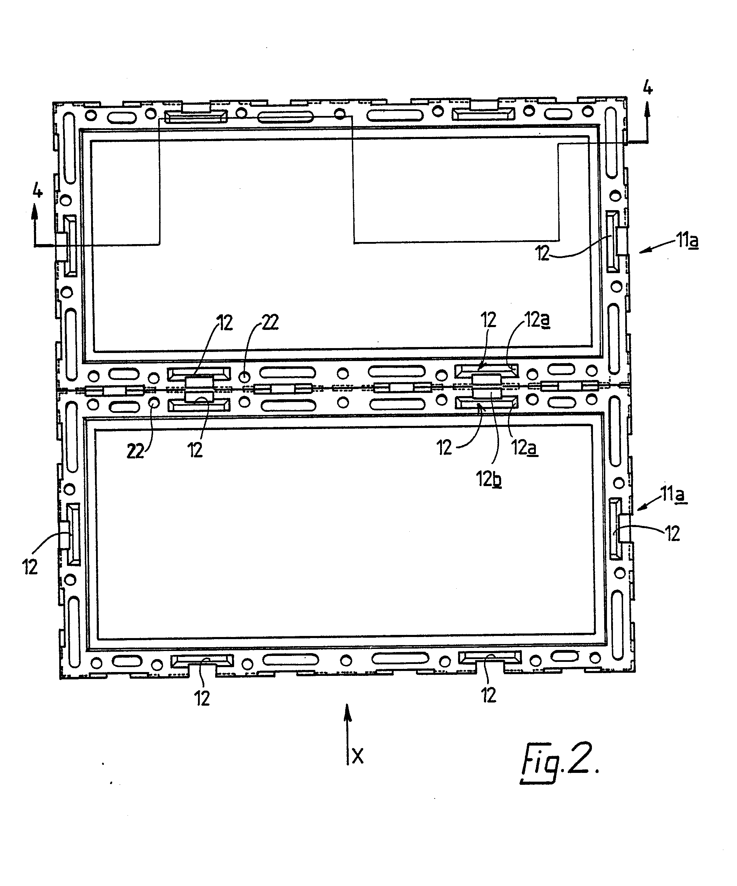

Referring to the drawings, the instrument housing is assembled from a plurality of individual housing units 11. The housing units 11 chosen to construct a given instrument housing will be selected from a plurality of different sizes and shapes of units which are available and which are compatible with one another. Thus Figure 1 shows a pair of units 10a, 10b of different sizes whereas Figure 2 shows a pair of units 11a, 11b of the same size and shape. Each of the units 11a, 11b is rectangular having a length dimension which is double the width dimension. Alternative units usable with the rectangular units 11 are square units such as the unit 10a of Figure 1 having a side dimension equal to the length dimension of the rectangular units 11, and other square units (not shown) having a side dimension which is equal to the width dimension of the rectangular units 11. The appropriate units are selected from stock and are placed side-by-side in the desired pattern to produce the required housing shape.

Each of the units is moulded in synthetic resin material, and is open at both ends. Thus in effect each unit is defined basically by a rectangular or square wall structure.

Each wall of each of the units is formed with one or more grooves 12 extending within the wall thickness from the lower face of the unit almost to the upper face of the unit. Where the wall of the unit is of small dimension such as the width dimension of the units 11a the groove 12 is centrally located. Where the wall dimension is large, for example the length dimension of the units 11a, 11b then that wall has a pair of grooves 12 each positioned a quarter of the way along the wall from a respective corner. It will be recognised therefore that when a pair of units such as the units 11a, 11b are placed side-by-side and aligned with one another, then their grooves 12 in the touching walls are immediately adjacent one another. Similarly, if one of the units 11a or 11b was rotated relative to the other through 90° to form an L-shape, grooves 12 would still be immediately adjacent one another. The same is true of the use of other units in the range, for example the large or small square units and it will be understood that whatever the mix of units, when the units are correctly aligned with one another then appropriate grooves 12 will be closely adjacent one another.

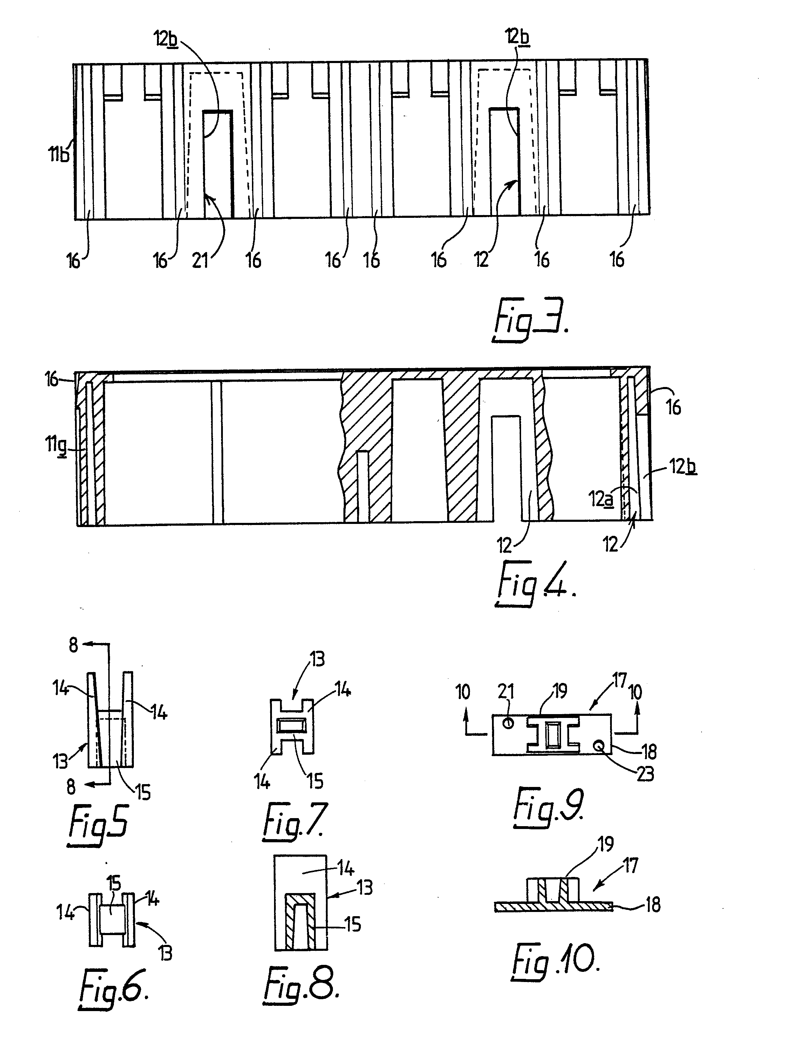

The grooves 12 are of T-shape cross-section in that they comprise a passage portion 12a of rectangular cross-section extending within the thickness of the wall from the lower face almost to the upper face of the unit, and a slot portion 12b which extends throughout the majority of the length of the passage portion 12a, and places the passage portion 12a in communication with the exterior of the unit. Each slot portion 12b extends from the lower face of the unit, parallel with the extent of the respective passage portion, but as is clear from Figures 3 and 4, terminates short of the upper face of the unit.

The width of the passage portion 12a of each groove 12 tapers from a maximum at the lower end of the groove to a minimum at the upper end of the groove. However, more important than this is that the breadth of the passage portion, that is to say the dimension measured across the thickness of the wall, also tapers from a maximum at the lower end of the groove to a minimum at the upper end of the groove. This taper is achieved by having the innermost wall of the passage portion 12a extending parallel to the axis of the unit, while the opposite, outermost wall of the passage portion 12a is inclined with respect to the innermost wall. The importance of this will become clear later.

In order to secure adjacent pairs of units together there is provided a plurality of connecting pieces 13. The connecting pieces 13 are moulded in synthetic resin and each comprises a pair of wedges 14 connected by an integral web 15. It can be seen from Figures 6 and 7 that the connecting piece 13 is thus generally H-shaped at its lower end, but not at its upper end since the wedges 14 project beyond the level of the web 15. Moreover, the outer faces of the wedges 14 are substantially parallel but their inner faces are inclined as is clear from Figures 5 and 7.

In use a pair of units, for example the units 11a and 11b are positioned side-by-side with their grooves 12 closely adjacent. A connecting piece 13 is then inserted into the or each pair of adjacent grooves 12 (a pair of connecting pieces 13 would be used in the arrangement of Figure 1). The uppermost, thinner ends of the wedges 14 are inserted into the passage portions 12a of the grooves 12 and the piece 13 is pressed into the grooves 12 so that the web 15 enters the slot portions 12b of the grooves 12. It will be recognised that the inclined inner faces of the wedges 14 coact with the inclined outer faces of the passage portions of the grooves 12 and as the connecting pieces are forced as far as possible into the grooves 12, the wedging action presses the units 11a, 11b firmly against one another.

It will be understood that the units 11 are moulded in synthetic resin material, and thus in order to facilitate removal of the moulded components from the moulding apparatus, the units 11 will be formed with a draw angle. In order therefore that the units are clamped together by the connecting pieces 13 such that their upper faces are co-planar, the outer faces of the walls of the units are provided with pads 16 which are not subject to the draw angle of the remainder of the mouldings, and whose faces are accurately at right-angles to the upper and lower faces of the units. The pad 16 of one unit of course corresponds with the pad 16 of the adjacent unit, and thus as the connecting pieces 13 are driven into position to clamp the units tightly against one another it is the pads 16 of the units which make contact and thereby ensure that the units are positioned relative to one another with their upper and lower faces accurately co-planar.

The width of each of the wedges 14 of each connecting piece 13 is so chosen in relation to the equivalent dimension of the passage portion 12a of the grooves 12 that passage of the wedge along the passage portion of its respective groove 12 will not be impeded by engagement of the lateral edges of the wedge with the equivalent surfaces of the passage portion of the groove. In this way it can be ensured that the connecting piece 13 can be driven sufficient far home into the adjacent pair of grooves to achieve tight clamping of the units against one another. However, this provision does mean that if friction between a pair of adjacent units can be overcome then the units may be capable of being twisted slightly relative to one another. There is not a huge clearance between the lateral edges of the wedges and the equivalent faces of the passage portions of the groove 12, and thus any twisting movement which could take place is minimal. Nevertheless, in order to prevent such twisting movement in use there is provided, in association with each connecting piece 13 a bridging member 17. Each bridging member 17 is also moulded from synthetic resin material and is generally in the form of a flat strip 18 having an H-section protrusion 19 extending from one face thereof. After driving a connecting piece 13 into its appropriate pair of grooves 12 the end face of the connecting piece 13 is above the level of the lower face of the units 11 (i.e. within the units 11). The H-shape protrusion 19 of a respective bridging member 17 is then introduced into the grooves 12, although it is not intended that the protrusion 19 should perform any additional wedging action. The protrusion 19 is introduced into the grooves until the plate 18 seats on the lower face of the units 11, whereupon the member 17 is secured to both units 11 by means of self-tapping screws. One screw passes through a first aperture 21 in the plate 18 and into an appropriate bore 22 of the unit 11a while the other screw is passed through an aperture 23 in the plate 18 and into an appropriate bore 22 of the unit 11b. In addition to resisting twisting movement of one unit relative to another, the bridge members 17 hold their respective connecting pieces 13 in position in the grooves 12.

It will be understood that a number of units of different sizes and shapes can be secured together by appropriate use of connecting pieces 13 and bridge members 17. Thereafter chosen instruments will be supported within the housing so defined, flanges on the instruments being secured, if necessary, by screws to the appropriate walls of the units of the housing in a manner similar to that described with reference to the bridging members 17. The bodies of the instruments will thus be received within the housing, and the lower face of the housing may be closed by one or more printed circuit board elements secured to the housing and providing appropriate electrical connections to, and interconnections between, the instruments.

Appropriate decorative bezzles 10c and baffles 10d can be provided as shown in Figure 1 for covering the upper face of the housing and encircling the instruments mounted therein to provide a good aesthetic finish. The bezzles 10c can, as shown, have resilient T-shaped legs 10e which engage formations 10f on the outer surface of the units 10, 11 as a snap fit to retain the bezzles. The bezzles in turn trap the baffle members (where provided) and can also be used to secure the instruments in position.

In order to facilitate mounting of a completed housing there is provided a plurality of mounting brackets 10a (Figure 1), each bracket having a portion equivalent to a wedge 14 of a connecting piece 13 which is inserted into wedging engagement with a groove 12 available at the periphery of the assembled housing. It will be recognised that none of the grooves 12 at the periphery of the assembled housing will be occupied by a connecting piece 13 since inevitably the grooves occupied by connecting pieces 13 will be within the housing assembly. Thus any of the grooves 12 at the periphery of the assembled housing is available wedgingly to receive the wedge portion of a mounting bracket. In addition to a wedge portion equivalent to a wedge 14 of a connecting piece 13 each bracket will have a plate portion which when the bracket is engaged with the groove 12, will seat upon the lower surface of the wall of the appropriate unit, and which is provided with one or more holes for receiving screws whereby the bracket can be screwed to the chosen unit. The bracket then protrudes from the periphery of the unit to provide a mounting for the housing.

CLAIMS:

1. A housing including first and second housing units (10a,10b) to be positioned side-by-side, and a connecting piece (13) which, when the two units are positioned side-by-side, is engageable simultaneously with both units, characterized in that the connecting piece (13) and the units (10a, 10b; 11a,11b) are such that during engagement of the connecting piece (13) with the units a wedging action is achieved pressing the two units together.

2. A housing as claimed in claim 1 characterized in that the units are moulded in a synthetic resin material, and are provided on their mutually presented faces with contact pads (16), the surfaces of which are parallel to the axis of their respective unit, the contact pads (16) of one unit engaging the contact pads (16) of the other unit when the two units are secured together so that the units are clamped together by the connecting piece (13) with their axes in parallel planes.

3. A housing as claimed in claim 1 or claim 2 characterised in that in addition to the connecting piece (13) there is provided a bridging member (17) which engages the first and second units in a manner to resist twisting of the units, and thus to position the units relative to one another so that their axes are parallel.

4.      A housing as claimed in any one of the preceding claims characterised in that said connecting piece (13) comprises a pair of wedge members (14) interconnected in spaced relationship by an integral limb (15) extending transverse to the length of the wedge members (14).

5.      A housing as claimed in any one of the preceding claims, characterised in that each unit is formed with a T-section slot (12) for receiving the respective wedge member (14) of a connecting piece (13).

6.      A housing as claimed in any one of the preceding claims characterised in that each unit receives a respective bezzle as a snap fit.

_Fig.1._

0148765

*Fig.2.*

3/3

0148765

Fig 3.

Fig 4.

Fig 5.

Fig.6.

Fig.7.

Fig.8.

Fig.9.

Fig.10.